# EUROPEAN PATENT SPECIFICATION

(11) **EP 4 084 272 B1**
(45) Date of publication and mention of the grant of the patent: **12.11.2025**
(21) Application number: 21170381.4
(22) Date of filing: 26.04.2021
(51) Int. Cl.: H02J 9/06, G01R 31/40

(54) **METHOD FOR TESTING AN ELECTRO-HYDRAULIC STEERING SYSTEM OF A VEHICLE AND ELECTRO-HYDRAULIC STEERING SYSTEM**
VERFAHREN ZUM PRÜFEN EINES ELEKTROHYDRAULISCHEN LENKSYSTEMS EINES FAHRZEUGS UND ELEKTROHYDRAULISCHES LENKSYSTEM
PROCÉDÉ POUR TESTER UN SYSTÈME DE DIRECTION ÉLECTRO-HYDRAULIQUE D'UN VÉHICULE ET SYSTÈME DE DIRECTION ÉLECTRO-HYDRAULIQUE

(43) Date of publication of application: 02.11.2022
(73) Proprietor: Danfoss Power Solutions ApS, 6430 Nordborg (DK)
(72) Inventor: Petersen, Morten Hoeck, 6430 Nordborg (DK)
(74) Representative: Keil & Schaafhausen Patentanwälte PartGmbB

(56) References cited:
- EP-A2- 1 056 181
- US-A1- 2014 210 262

## Description

The present invention relates to a method for testing a backup battery of an electro-hydraulic steering system of a vehicle, the system having two parallel branches, wherein each branch is able to control the steering of the vehicle and the system comprises a main electric power supply connected to both branches, wherein at least one of the branches is connected to a backup battery.

Furthermore, the invention relates to an electro-hydraulic steering system of a vehicle, the system having two parallel branches and a backup battery, wherein each branch is able to control the steering of the vehicle and the system comprises a main electrical power supply connected to both branches, wherein at least one of the branches is connected to a backup battery.

Such a steering system can be in form of a steer-by-wire system which is fail operational because of the two parallel branches. When one branch fails, the other branch is able to allow a controlled steering of the vehicle. Each of the branches comprises at least one component which requires electrical energy. This energy is usually provided by the main electric power supply. The main electrical power supply comprises in most cases a main battery and an alternator driven by an engine of the vehicle. However, in order to be fail operational even in case of a failure of the main electrical power supply, the backup battery is used.

US 2014/210262 A1 shows an electro-hydraulic steering system having a single branch. The electro-hydraulic steering system is connected to a main battery and to a backup battery. EP 1056181 A2 shows a similar system.

The object underlying the invention is to provide for a simple way to test the backup battery.

This object is solved in that testing is performed by disconnecting the main electrical power supply from the branch connected to the backup battery and using the branch connected to the backup battery as test load of the backup battery.

In this way it is possible to check whether the backup battery is still in a condition which allows the operation of the branch connected to the backup battery. When this branch can be operated, this is an indication that the backup battery supplies enough electrical power to drive the respective components of the branch which need such a power. When both branches are provided with a backup battery, the test can be performed independently for both branches.

In an embodiment of the invention the testing is periodically repeated. Thus, the backup battery is tested from time to time.

In an embodiment of the invention the voltage of the backup battery is observed. This is a simple way to find out whether testing is performed under the desired conditions. When the main electrical power supply is disconnected from the branch and only the backup battery is used to supply electrical power it is to be expected that the voltage at the backup battery decreases. If such a voltage drop is not observed, it is an indication that the main electrical power supply has not been disconnected and a corresponding error message can be outputted.

In an embodiment of the invention the main electrical power supply is disconnected over a time period of predetermined length and a discharge curve of the backup battery is recorded. This can be used to monitor the health of battery status of the backup battery.

In an embodiment of the invention the discharge curve is used to extrapolate the battery status of the backup battery. When the discharge curve shows, for example, the development of the voltage of the backup battery over the time, a backup battery having a "good" battery status will show a sufficiently high voltage over a longer time period than a backup battery which is no longer fit for the purpose of the backup battery. Thus, the backup battery can be replaced, when it is necessary. The necessity can be indicated by the extrapolation.

In an embodiment of the invention the backup battery is permanently connected to a branch, wherein a current flow from the backup battery to the main electrical power supply is blocked. Thus, it is not necessary to connect the backup battery in case of a failure. The backup battery can under normal conditions permanently be charged by the main electrical power supply. However, there is no current flow from the backup battery to the main electrical power supply. Such a blocking can be achieved, for example, by a diode or another semiconductor.

The object is solved with an electro-hydraulic steering system of a vehicle as described at the outset, in that a switch is arranged between the main electrical power supply and the branch connected to the backup battery for disconnecting the branch connected to the battery from the main power supply, wherein the branch connected to the backup battery forms a test load for the backup battery.

The switch can be used to disconnect the main electrical power supply from the backup battery and, since the backup battery is connected to the branch, from the respective branch. Thus, when the switch has been opened, the branch of the steering system is supplied with electrical power only from the backup battery. When the branch still works, this is an indication that the backup battery is still suitable for the purpose of a backup battery. If the branch cannot be operated, this is an indication that the backup battery is no longer able to provide sufficient electrical power.

In an embodiment of the invention the switch is in form of a relay. A relay is a switch which can be remotely operated by means of electrical current.

In an embodiment of the invention the relay is a normally closed relay. In other words, the main electrical power supply is connected to the branch and to the backup battery unless the relay is open. Such an opening is made only for testing purposes.

In an embodiment of the invention a charge circuit is arranged between the backup battery and the main electrical power supply, the charge circuit blocking a current flow from the backup battery to the main electrical power supply. Thus, the backup battery is not emptied when the main electrical power supply fails.

In an embodiment of the invention charge circuit comprises a diode. This is a simple way to realize a charge circuit.

In an embodiment of the invention the voltage detection means are connected to a comparator comparing a voltage of the backup battery with a predetermined voltage. This comparator can be used to detect whether the switch has been opened or not. When the switch has been opened, the voltage of the backup battery will drop which can be detected by comparing the voltage of the backup battery with the predetermined voltage. If the voltage of the backup battery does not drop, this is a clear indication that the branch is still supplied with electrical energy from the main electrical power supply.

In an embodiment of the invention the voltage detection means are connected to evaluation means evaluating a battery status of the backup battery on basis of a discharge curve of the backup battery. The discharge curve can be a recording of the voltage over time. It is also possible to record other electrical characteristics of the battery, like internal resistance or current output.

A preferred embodiment of the invention will now be described with reference to the drawing, wherein:
- Fig. 1: shows schematically an electro-hydraulic steering system and
- Fig. 2: shows schematically electrical components of a power supply arrangement.

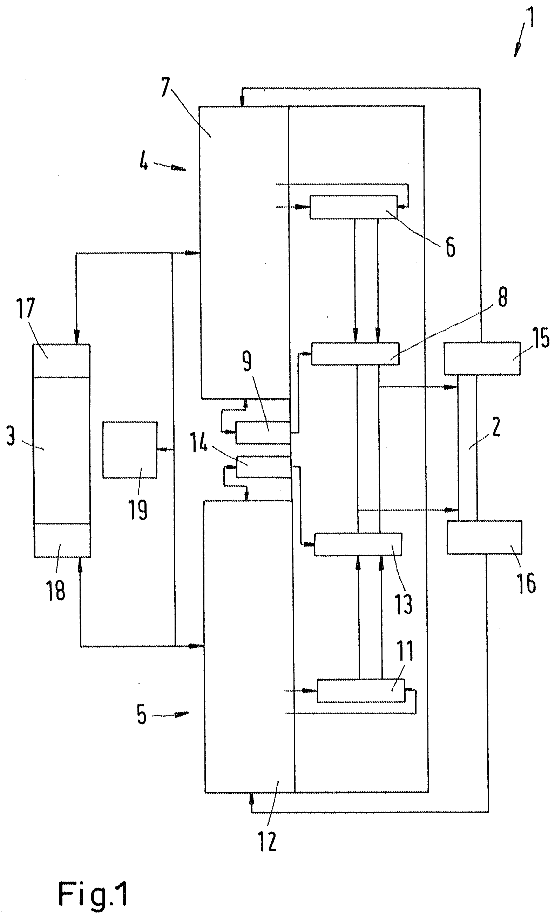

Fig. 1 schematically shows an electro-hydraulic steering system 1 having a steering motor 2, for example in form of a steering cylinder or in form of an arrangement of steering cylinders. The steering system 1 comprises a steering device 3, for example in form of a steering wheel or in form of a joystick.

Supply of hydraulic fluid to the steering motor 2 is controlled by two branches 4, 5 which are arranged in parallel. The first branch 4 comprises a main spool 6 which is hydraulically driven by means of a pilot valve arrangement 7. The pilot valve arrangement 7 comprises, for example, an arrangement of four solenoid valves which are arranged in a bridge, as it is known. However, the pilot valve arrangement 7 requires electrical power to operate.

The first branch 4 comprises a safety valve 8 which is driven by a safety valve solenoid 9 which requires likewise electrical energy.

The second branch 5 is of identical construction. It comprises a main spool 10 which is driven by a pilot valve arrangement 12. Furthermore, it comprises a safety valve 13 which is driven by a safety valve solenoid 14. The pilot valve arrangement 12 and the safety valve solenoid 14 require electrical energy.

A first wheel angle sensor 15 and a second wheel angle sensor 16 are provided to detect the steering angle of steered wheels. The wheel angle sensors 15, 16 can also be directly connected to the steering motor 2.

Furthermore, the steering device 3 can be provided with sensors 17, 18. Finally, an MMI-service tool 19 can be provided triggering a calibration of the steering system.

As mentioned above, the steering system requires electrical power in order to operate components which need electrical power, in particular the solenoids of some valves.

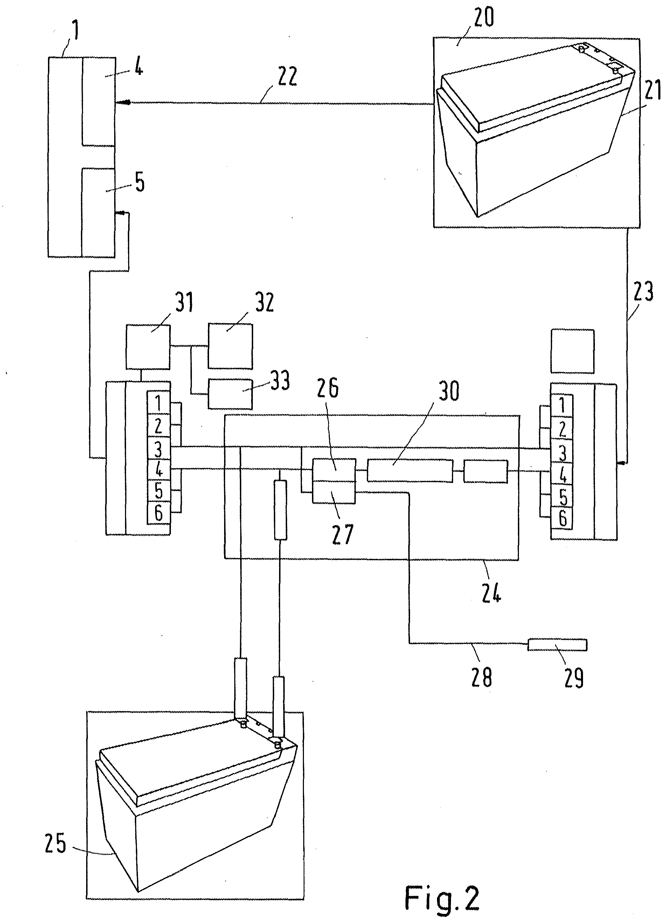

In order to provide such electrical energy, some components are necessary, which are schematically shown in Fig. 2.

Fig. 2 shows again the electro-hydraulic steering system 1 having the two branches 4, 5. The first branch 4 is connected to a main electrical power supply 20. The main electrical power supply 20 comprises a main battery 21 and an alternator (not shown). A connection between the main electrical power supply 20 and the first branch 4 is schematically shown by a line 22.

The second branch 5 needs also supply of electrical energy. Thus, the second branch 5 is also connected to the main electrical power supply by means of a connection 23. However, connection 23 is different from line 22 in that it comprises a number of components which are shown in box 24.

First of all, branch 5 is connected to a backup battery 25 which can be smaller than the main battery 21.

Furthermore, box 24 shows a switch 26 which is arranged in the connection between the main battery 21 and the second branch 5. When the switch 26 is opened, it interrupts also a connection between the main electrical power supply 20 and the backup battery 25.

The switch 26 is in form of a relay having a coil 27. The coil 27 is energized via a line 28 by means of a control 29. The relay is a normally closed relay, i.e. when there is no current supplied to the coil 27, the switch 26 is closed.

Furthermore, a diode 30 is arranged between the main electrical power supply 20 and the backup battery 25, so that a flow of current is only possible in a direction from the main electrical power supply 20 towards the second branch 5 and towards the backup battery 25, however, not in the opposite direction. It should be noted that a more intelligent charge circuit can be used instead of the diode 30.

Voltage detection means 31 are provided to detect the output voltage of the backup battery 25. The voltage detection means 31 are connected to a comparator 32. The comparator 32 compares a voltage of the backup battery 25 with a predetermined voltage. When the switch 26 is opened, the second branch 5 of the electro-hydraulic steering system 1 forms the load for the backup battery 25. When the second branch 5 consumes electrical power, it is to be expected that the voltage at the output of the backup battery 25 drops a bit. When such a voltage drop is observed, this is an indication that the switch 26 has been opened. When the voltage drop is not observed, this is a clear indication that the switch 26 has not been opened. Furthermore, the voltage detection means 31 are connected to evaluation means 33 evaluating a battery status of the backup battery 25 on basis of a discharge curve of the backup battery. To this end, the main electrical power supply 20 is disconnected from the second branch 5 over a time period of predetermined length and a discharge curve of the backup battery is recorded. The discharge curve can show, for example, the voltage of the backup battery over the time. A backup battery having a good or sufficient battery status will keep the voltage almost constant over time. When the voltage decreases over time faster than it would be expected, this is an indication that the battery status is no longer acceptable, and it is possible to replace the battery before a failure occurs.

It is also possible to extrapolate the battery status from the discharge curve. This means that the backup battery needs not to be fully discharged.

The test of the backup battery is periodically repeated, for example once a day or every hour.

Testing is performed in a simple way.

The switch 26 is opened by supplying current to the coil 27. Thus, the connection between the main electrical power supply 20 and the backup battery 25 is interrupted and the backup battery 25 is the only power source for operation of the second branch 5. When the second branch 5 continues to operate, and if there is a voltage drop from the voltage of the main electrical power supply 20 to voltage of the backup battery 25, the switch 26 did in fact open. If the branch 5 dies, the backup battery 25 is not connected or not able to provide enough energy. If the voltage does not drop, the switch 26 did not open.

The backup battery 25 could be duplicated to also be in the other branch 4. In case of two backup batteries, the test of the two batteries should be separated in time.

## Claims

1. Method for testing a backup battery (25) of an electro-hydraulic steering system (1) of a vehicle, the system (1) having two parallel branches (4, 5), wherein each branch (4, 5) is able to control the steering of the vehicle and the system (1) comprises a main electrical power supply (20) connected to both branches (4, 5), wherein at least one of the branches (5) is connected to the backup battery (25), wherein testing is performed by disconnecting the main electrical power supply (20) from the branch (5) connected to the backup battery (25) and using the branch (5) connected to the backup battery (25) as test load of the backup battery (25).

2. Method according to claim 1, **characterized in that** testing is periodically repeated.

3. Method according to claim 1 or 2, **characterized in that** the voltage of the backup battery (25) is observed.

4. Method according to claim 3, **characterized in that** the main electrical power supply (20) is disconnected over a time period of predetermined length and a discharge curve of the backup battery (25) is recorded.

5. Method according to claim 4, **characterized in that** the discharge curve is used to extrapolate the battery status of the backup battery (25).

6. Method according to any of claims 1 to 5, **characterized in that** the backup battery (25) is permanently connected to a branch (5), wherein a current flow from the backup battery (25) to the main electrical power supply (20) is blocked.

7. Electro-hydraulic steering system (1) of a vehicle, the system having two parallel branches (4, 5), wherein each branch (4, 5) is able to control the steering of the vehicle, and the system (1) comprises a main electrical power supply (20) connected to both branches (4, 5) and a backup battery (25), wherein at least one of the branches (5) is connected to the backup battery (25), wherein a switch (26) is arranged between the main electrical power supply (20) and the branch (5) connected to the backup battery (25) for disconnecting the branch (5) connected to the backup battery (25) from the main power supply (20), wherein the system (1) comprises means configured to test the backup battery (5) by using the branch (5) connected to the backup battery (25) as a test load for the backup battery (25).

8. Electro-hydraulic steering system according to claim 7, **characterized in that** voltage detection means (31) are connected to the backup battery (25).

9. Electro-hydraulic steering system according to claim 7 or 8, **characterized in that** the switch (26) is in form of a relay.

10. Electro-hydraulic steering system according to claim 9, **characterized in that** the relay is a normally closed relay.

11. Electro-hydraulic steering system according to any of claims 7 to 10, **characterized in that** a charge circuit diode (30) is arranged between the backup battery (25) and the main electrical power supply (20), the charge circuit blocking a current flow from the backup battery (25) to the main electrical power supply (20).

12. Electro-hydraulic steering system according to claim 11, **characterized in that** the charge circuit comprises a diode (30).

13. Electro-hydraulic steering system according to any of claims 8 to 12, **characterized in that** the voltage detection means (31) are connected to a comparator (32) comparing a voltage of the backup battery (25) with a predetermined voltage.

14. Electro-hydraulic steering system according to any of claims 8 to 13, **characterized in that** the voltage detection means (31) are connected to evaluation means (33) evaluating a battery status of the backup battery (25) on basis of a discharge curve of the backup battery (25).

## Patentansprüche

1. Verfahren zum Testen einer Reservebatterie (25) eines elektrohydraulischen Lenksystems (1) eines Fahrzeugs, wobei das System (1) zwei parallele Zweige (4, 5) aufweist, wobei jeder Zweig (4, 5) in der Lage ist, die Lenkung des Fahrzeugs zu steuern, und das System (1) eine elektrische Hauptstromversorgung (20) umfasst, die mit beiden Zweigen (4, 5) verbunden ist, wobei mindestens einer der Zweige (5) mit der Reservebatterie (25) verbunden ist, wobei das Testen durch Trennen der Hauptstromversorgung (20) von dem mit der Reservebatterie (25) verbundenen Zweig (5) und Nutzen des mit der Reservebatterie (25) verbundenen Zweigs (5) als Testlast für die Reservebatterie (25) durchgeführt wird.

2. Verfahren nach Anspruch 1, **dadurch gekennzeichnet, dass** das Testen periodisch wiederholt wird.

3. Verfahren nach Anspruch 1 oder 2, **dadurch gekennzeichnet, dass** die Spannung der Reservebatterie (25) beobachtet wird.

4. Verfahren nach Anspruch 3, **dadurch gekennzeichnet, dass** die Hauptstromversorgung (20) über einen Zeitraum vorbestimmter Länge getrennt wird und eine Entladungskurve der Reservebatterie (25) aufgezeichnet wird.

5. Verfahren nach Anspruch 4, **dadurch gekennzeichnet, dass** die Entladungskurve verwendet wird, um den Batteriestatus der Reservebatterie (25) zu extrapolieren.

6. Verfahren nach einem der Ansprüche 1 bis 5, **dadurch gekennzeichnet, dass** die Reservebatterie (25) permanent mit einem Zweig (5) verbunden ist, wobei ein Stromfluss von der Reservebatterie (25) zu der Hauptstromversorgung (20) blockiert ist.

7. Elektrohydraulisches Lenksystem (1) eines Fahrzeugs, wobei das System zwei parallele Zweige (4, 5) aufweist, wobei jeder Zweig (4, 5) dazu in der Lage ist, die Lenkung des Fahrzeugs zu steuern, und das System (1) eine Hauptstromversorgung (20), die mit beiden Zweigen (4, 5) verbunden ist, und eine Reservebatterie (25) umfasst, wobei mindestens einer der Zweige (5) mit der Reservebatterie (25) verbunden ist, wobei zwischen der Hauptstromversorgung (20) und dem mit der Reservebatterie (25) verbundenen Zweig (5) ein Schalter (26) zum Trennen des mit der Reservebatterie (25) verbundenen Zweigs (5) von der Hauptstromversorgung (20) angeordnet ist, wobei das System (1) Mittel umfasst, die dazu eingerichtet sind, die Reservebatterie (25) durch Nutzen des mit der Reservebatterie (25) verbundenen Zweigs (5) als Testlast für die Reservebatterie (25) zu verwenden.

8. Elektrohydraulisches Lenksystem nach Anspruch 7, **dadurch gekennzeichnet, dass** Spannungserfassungsmittel (31) mit der Reservebatterie (25) verbunden sind.

9. Elektrohydraulisches Lenksystem nach Anspruch 7 oder 8, **dadurch gekennzeichnet, dass** der Schalter (26) in Form eines Relais ausgebildet ist.

10. Elektrohydraulisches Lenksystem nach Anspruch 9, **dadurch gekennzeichnet, dass** das Relais ein normalerweise geschlossenes Relais ist.

11. Elektrohydraulisches Lenksystem nach einem der Ansprüche 7 bis 10, **dadurch gekennzeichnet, dass** eine Ladeschaltungsdiode (30) zwischen der Reservebatterie (25) und der Hauptstromversorgung (20) angeordnet ist, wobei die Ladeschaltung einen Stromfluss von der Reservebatterie (25) zu der Hauptstromversorgung (20) blockiert.

12. Elektrohydraulisches Lenksystem nach Anspruch 11, **dadurch gekennzeichnet, dass** der Ladestromkreis eine Diode (30) umfasst.

13. Elektrohydraulisches Lenksystem nach einem der Ansprüche 8 bis 12, **dadurch gekennzeichnet, dass** die Spannungserfassungsmittel (31) mit einem Komparator (32) verbunden sind, der eine Spannung der Reservebatterie (25) mit einer vorgegebenen Spannung vergleicht.

14. Elektrohydraulisches Lenksystem nach einem der Ansprüche 8 bis 13, **dadurch gekennzeichnet, dass** die Spannungserfassungsmittel (31) mit Auswertmitteln (33) verbunden sind, die einen Batteriestatus der Reservebatterie (25) auf der Grundlage einer Entladungskurve der Reservebatterie (25) auswerten.

## Revendications

1. Procédé de test d'une batterie de secours (25) d'un système de direction électrohydraulique (1) d'un véhicule, le système (1) ayant deux branches parallèles (4, 5), où chaque branche (4, 5) est capable de commander la direction du véhicule et le système (1) comprend une alimentation électrique principale (20) reliée aux deux branches (4, 5), où au moins l'une des branches (5) est reliée à la batterie de secours (25), où le test est réalisé en débranchant l'alimentation électrique principale (20) de la branche (5) reliée à la batterie de secours (25) et en utilisant la branche (5) reliée à la batterie de secours (25) comme charge de test de la batterie de secours (25).

2. Procédé selon la revendication 1, **caractérisé en ce que** le test est répété périodiquement.

3. Procédé selon la revendication 1 ou 2, **caractérisé en ce que** la tension de la batterie de secours (25) est observée.

4. Procédé selon la revendication 3, **caractérisé en ce que** l'alimentation électrique principale (20) est débranchée pendant une période de durée prédéterminée et une courbe de décharge de la batterie de secours (25) est enregistrée.

5. Procédé selon la revendication 4, **caractérisé en ce que** la courbe de décharge est utilisée pour extrapoler l'état de batterie de la batterie de secours (25).

6. Procédé selon l'une des revendications 1 à 5, **caractérisé en ce que** la batterie de secours (25) est reliée en permanence à une branche (5), où un flux de courant de la batterie de secours (25) à l'alimentation électrique principale (20) est bloqué.

7. Système de direction électrohydraulique (1) d'un véhicule, le système ayant deux branches parallèles (4, 5), où chaque branche (4, 5) est capable de commander la direction du véhicule, et le système (1) comprend une alimentation électrique principale (20) reliée aux deux branches (4, 5) et une batterie de secours (25), où au moins l'une des branches (5) est reliée à la batterie de secours (25), où un commutateur (26) est agencé entre l'alimentation électrique principale (20) et la branche (5) reliée à la batterie de secours (25) pour débrancher la branche (5) reliée à la batterie de secours (25) de l'alimentation principale (20), où le système (1) comprend des moyens configurés pour tester la batterie de secours (5) en utilisant la branche (5) reliée à la batterie de secours (25) comme charge de test pour la batterie de secours (25).

8. Système de direction électrohydraulique selon la revendication 7, **caractérisé en ce que** des moyens de détection de tension (31) sont reliés à la batterie de secours (25).

9. Système de direction électrohydraulique selon la revendication 7 ou 8, **caractérisé en ce que** le commutateur (26) est sous forme de relais.

10. Système de direction électrohydraulique selon la revendication 9, **caractérisé en ce que** le relais est un relais normalement fermé.

11. Système de direction électrohydraulique selon l'une des revendications 7 à 10, **caractérisé en ce qu'**une diode de circuit de charge (30) est agencée entre la batterie de secours (25) et l'alimentation électrique principale (20), le circuit de charge bloquant le flux de courant de la batterie de secours (25) à l'alimentation électrique principale (20).

12. Système de direction électrohydraulique selon la revendication 11, **caractérisé en ce que** le circuit de charge comprend une diode (30).

13. Système de direction électrohydraulique selon l'une des revendications 8 à 12, **caractérisé en ce que** les moyens de détection de tension (31) sont reliés à un comparateur (32) comparant la tension de la batterie de secours (25) à une tension prédéterminée.

14. Système de direction électrohydraulique selon l'une des revendications 8 à 13, **caractérisé en ce que** les moyens de détection de tension (31) sont reliés à des moyens d'évaluation (33) évaluant un état de batterie de la batterie de secours (25) sur la base d'une courbe de décharge de la batterie de secours (25).
